# EUROPÄISCHE PATENTSCHRIFT

(11) **EP 2 565 292 B1**
(45) Veröffentlichungstag und Bekanntmachung des Hinweises auf die Patenterteilung: **13.08.2014**
(21) Anmeldenummer: 12007846.4
(22) Anmeldetag: 20.04.2011
(51) Int. Cl.: C23C 14/24, C23C 14/30, C23C 14/56, H01J 37/305

(54) **VORRICHTUNG UND VERFAHREN ZUM BESCHICHTEN VON SUBSTRATEN NACH DEM EB/PVD-VERFAHREN**
APPARATUS AND METHOD FOR COATING SUBSTRATES USING THE EB/PVD PROCESS
DISPOSITIF ET PROCÉDÉ DE REVÊTEMENT DE SUBSTRATS SELON LE PROCÉDÉ DE DÉPÔT PAR ÉVAPORATION SOUS BOMBARDEMENT ÉLECTRONIQUE

(30) Priorität: 21.04.2010 DE 102010017896
(43) Veröffentlichungstag der Anmeldung: 06.03.2013
(62) Teilanmeldung aus: 11743417.5
(73) Patentinhaber: ALD Vacuum Technologies GmbH, 63450 Hanau (DE)
(72) Erfinder: Schuhmann, Gerhard, D-63829 Krombach (DE); Hotz, Jürgen, D-64839 Münster (DE); Seserko, Pavel, D-63791 Karlstein (DE); Schwagmann, Johannes, D-63607 Wächtersbach (DE); Lemke, Jürgen, D-69469 Weinheim (DE); Wittich, Jörg, D-64853 Otzberg (DE)
(74) Vertreter: Hebing, Norbert

(56) Entgegenhaltungen:
- DE-A1-102004 006 849

## Beschreibung

Die Erfindung bezieht sich auf ein Verfahren zum Betreiben einer Vorrichtung zum Beschichten von Substraten mit einem Beschichtungsmaterial nach dem EB/PVD-Verfahren mit einer aus wenigstens zwei Beschichtungsmaterial enthaltenden Tiegeln bestehenden Tiegelanordnung.

Die Tiegel befinden sich in einem Tiegelkopf und werden über Schächte mit Material versorgt, wobei mit unterschiedlichen Materialien gefüllt werden, wobei ein Material, das für die Beschichtung der Substrate häufiger benötigt wird als andere, auch in zwei oder mehr Schächten angeordnet werden kann. Die einzelnen Schichten können nun nachfolgend aufgebracht werden, indem ein Karussell mit dem Tiegelkopf jeweils soweit gedreht wird, dass sich der Tiegel mit dem aktuell zu verdampfenden Material in einer Arbeitsposition befindet, in der er vom Elektronenstrahl erreicht wird, das heißt, sich nicht im Schatten der zu beschichten Substrate und deren Halter befindet.

Solche Tiegelanordnungen in EB-PVD Verfahren sind beispielsweise in der DE 10 2004 006 849 A1 offenbart.

Im Tiegelkopf befindet sich ein weiterer Tiegel, der über keine Materialstangenzufuhr verfügt und als Dummytiegel bezeichnet wird. In diesen Tiegel wird ein zu verdampfendes Material eingebracht. Dies ermöglicht es, den Elektronenstrahl in eine Ruhe- oder Zwischenposition zu bringen, die für das weiter unten beschriebene Verfahren benötigt wird.

Das Problem der Abschattung tritt auf, weil die Elektronenkanone oberhalb der Beschichtungszone, in denen sich die zu beschichtenden Substrate befinden, angeordnet ist. Da die Substrate und deren Halter die Beschichtungszone weitgehend ausfüllen, verbleibt nur ein beschränkter Raum zur Führung des Elektronenstrahls.

Bei einem Wechsel der Tiegelposition tritt nun das folgende Problem auf: Die Drehung des Tiegelkopfes benötigt einige Zeit. Dabei kann der Strahl dem Tiegel nicht in abgeschattete Bereiche folgen, so dass der Strahl so lang auf außerhalb der Tiegel liegende Bereiche des Tiegelkopfes gerichtet ist, bis der nächste Tiegel in seinen Einwirkungsbereich gelangt. Um Beschädigungen dieser Bereiche wenigstens zu minimieren, wird der Strahl defokussiert, so dass die eingetragene Strahlenergie gering bleibt. Trotz dieser Maßnahmen können Beschädigungen aber nicht gänzlich ausgeschlossen werden.

Erfindungsgemäß wird daher im Tiegelkopf ein weiterer Tiegel angeordent, der über keine Materialstangenzufuhr verfügt und als Dummytiegel bezeichnet wird. In diesen Tiegel wird ein zu verdampfendes Material eingebracht. Dies ermöglicht es, den Elektronenstrahl in eine Ruhe- oder Zwischenposition zu bringen, die für das weiter unten beschriebene Verfahren benötigt wird.

Erfindungsgemäß wird der Elektronenstrahl während der Drehung des Tiegelkopfes auf den im Zentrum des Tiegelkopfes angeordneten Dummytiegel gerichtet, der auch bei einer Drehung des Tiegelkopfes stets im Wirkungsbereich des Elektronenstrahls liegt Die Ablenkbewegung erfolgt sehr schnell und deutlich schneller als die Drehbewegung des Tiegelkopfes, so dass der Elektronenstrahl sich nur kurzzeitig auf außerhalb der Tiegel liegende Bereiche des Tiegelkopfes befindet und damit der Energieeintrag in die Oberfläche des Tiegelkopfes so gering bleibt, dass Beschädigungen nicht zu erwarten sind.

Ein weiteres Problem besteht darin, dass das Material im neuen Tiegel, das heißt in dem Tiegel, der sich nach einer Drehung des Tiegelkopfes in der Arbeitsposition befindet, noch kalt ist. Um ein zu rasches Aufheizen des Materials zu verhindern, bei dem es zu einer zu vermeidenden Spritzerbildung kommen würde, wird in der Regel die Strahlenergie gemindert. Dies hat aber den Nachteil, dass der Energieeintrag in die Beschichtungszone insgesamt verringert wird, so dass die Temperatur darin sinkt und damit auch die Temperatur der Substrate, was wiederum die Schichtqualitäten negativ beeinflusst.

Es besteht daher das Problem, einerseits den Energieeintrag in das zu verdampfende Material nur langsam erhöhen zu dürfen und gleichzeitig die Temperatur der Substrate zu halten.

Zur Lösung des Problems sieht daher die Erfindung vor, dass die Vorrichtung einen Tiegel mit einem Dummymaterial aufweist und dass der Elektronenstrahl bei einem Wechsel auf einen neuen Tiegel alternierend zwischen dem neuen Tiegel und dem Dummytiegel hin und her bewegt wird, wobei der Elektronenstrahl, wenn er sich auf dem Dummytiegel befindet, gegebenenfalls defokussiert ist.

Dadurch bleibt der Energieeintrag des Strahles in die Beschichtungszone konstant, so dass eine Temperaturänderung nicht zu erwarten ist. Gleichzeitig bleibt durch den alternierenden Wechsel zwischen dem neuen Tiegel und dem Dummytiegel der Energieeintrag in den neuen Tiegel zunächst gering, so dass es nicht zu Spritzerbildungen kommt.

Die Steuerung des Energieeintrags in den neuen Tiegel kann auch dadurch erfolgen, dass der Elektronenstrahl im Bereich des neuen Tiegels zunächst defokussiert ist und mit jeder Periode der alternierenden Bewegung stärker fokussiert wird. Des Weiteren kann auch mit jeder Periode die Verweildauer auf dem neuen Tiegel erhöht werden, bis sie vollständig ist, also keine alternierende Bewegung mehr vollzogen wird.

Die Erfindung bezieht sich außerdem auf eine Vorrichtung zum Beschichten von Substraten mit Beschichtungsmaterial nach dem EB/PVD-Verfahren mit einer aus wenigstens zwei Tiegeln bestehenden Tiegelanordnung in einem Tiegelkopf, wobei jeder Tiegel in einem ihm zugeordneten horizontal versetzbaren Gestell angeordnet ist und in jedem Gestell unterhalb des jeweiligen Tiegels ein Schacht zur Aufnahme einer aus dem Beschichtungsmaterial bestehenden Materialstange angeordnet ist, und mit mindestens einer Hubeinrichtung, mit deren Hilfe eine in dem Schacht angeordnete Materialstange durch den Boden des Tiegels in den Tiegel einführbar ist, um dort durch den Beschuss mit einem Elektronenstrahl aus einer Elektronenkanone verdampft zu werden.

Eine derartige Anordnung ist bekannt. Am Kopf eines Karussells, das ein einheitliches Gestell für Tiegel bildet, sind zwei Paar Tiegel symmetrisch angeordnet, so dass durch eine 180°-Drehung des Karussells die Tiegel des einen Paares kreuzweise ihren Platz mit den Tiegeln des anderen Paares tauschen. Unterhalb eines jeden Tiegels befindet sich ein Revolver mit mehreren Schächten, in denen Materialstangen bevorratet werden. Jede Materialstange besteht aus mehreren kurzen vollzylindrischen Teilstücken. Ist eine Materialstange bis auf das letzte Teilstück aufgebraucht, wird dieses im Tiegel eingeklemmt, so dass sich der Revolver unter dem Tiegel soweit ungehindert drehen kann, bis sich wieder ein gefüllter Schacht des Revolvers unter dem Tiegel befindet. Die Hubeinrichtung schiebt die neue Materialstange gegen das im Tiegel verbliebene Teilstück, dessen Klemmung danach aufgehoben wird. Da das nachgeschobene Material dem Material des verbliebenen Teilstückes entsprechen muss, kann ein Revolver nur mit Materialstangen aus einem Material gefüllt werden. Somit können bei der bekannten Vorrichtung nur zwei unterschiedliche Materialien zum Bedampfen genutzt werden, die jeweils den Tiegeln eines Paares zugeführt werden. Damit wird zwar jedem Tiegel ein relativ großer Vorrat an Material zur Verfügung gestellt, eine Beschichtung der Substrate mit mehr als zwei unterschiedlichen Materialien ist aber nicht möglich. Die Hubeinrichtung besteht aus Spindelantrieben, die an der Wand der Vakuumkammer befestigt sind, in denen die Vorrichtung angeordnet ist.

Die Erfindung beruht auf der Aufgabe, eine kompakte Anlage zu schaffen, mit denen gegebenenfalls auch mehr als zwei Schichten auf einem Substrat aufgebracht werden können.

Zur Lösung des Problems sieht daher die Erfindung vor, dass jedem Tiegel genau ein Schacht und genau eine Hubeinrichtung zugeordnet ist und dass die Hubeinrichtungen und der jeweils zugehörige Schacht auf dem dem Tiegel zugehörigen Gestell angeordnet sind und mit diesen seitlich versetzt werden, wobei sich Im Tiegelkopf sich ein weiterer Tiegel befindet, der über keine Materialstangenzufuhr verfügt und als Dummytiegel bezeichnet wird. In diesen Tiegel wird ein zu verdampfendes Material eingebracht. Dies ermöglicht es, den Elektronenstrahl in eine Ruhe- oder Zwischenposition zu bringen, die für das weiter unten beschriebene Verfahren benötigt wird.

Diese erfindungsgemäße Vorrichtung hat den Vorteil, dass eine nur von der Größe der Vakuumkammer begrenzte, ansonsten beliebige Anzahl von Tiegeln, deren Schächte mit unterschiedlichem Material bestückt sein können, zur Verfügung gestellt werden. Anstelle eines Tiegels, der mittels eines Revolvers mit mehreren Schächten gekoppelt werden kann, sieht die vorliegende Erfindung vor, dass jedem Schacht ein eigener Tiegel zugeordnet ist.

Die Tiegel können beliebig linear oder drehend versetzt werden, da die zugehörigen Hubeinrichtungen jeweils mit versetzt werden. Im Stand der Technik bestand insofern eine Einschränkung, da die Hubeinrichtungen am Gehäuse der Vakuumkammer fest angeordnet sind, und somit die Tiegel eine definierte Position einnehmen müssen, damit die Hubeinrichtungen die Materialstangen des jeweils aktuellen Tiegels erreichen können.

Grundsätzlich können die Gestelle beliebig angeordnet werden, z. B. ist eine kettenförmige Anordnung möglich, wobei jedes Gestell einen Antrieb aufweist, um es horizontal zu versetzen. Vorzugsweise sind die Gestelle aber Teilbereiche eines Karussells, das um eine vertikale Achse drehbar ist und vorzugsweise mit einem zentralen Antrieb versehen ist.

Die Tiegel sind vorzugsweise um die vertikal ausgerichtete Achse des Karussells herum angeordnet, so dass jeweils ein Tiegel durch eine Drehung des Karussells in eine bestimmte, von der Elektronenkanone erreichbare Arbeitsposition gedreht werden kann.

Ein einfacher Aufbau wird erreicht, wenn das Karussell einen oberen Drehteller und einen unteren Drehteller aufweist, wobei der untere Drehteller vakuumdicht im Boden der Vakuumkammer gelagert ist. Dabei werden die Antriebswellen für die Hubeinrichtung durch den unteren Drehteller vakuumdicht hindurchgeführt, so dass sich die Motoren für die einzelnen Antriebswellen außerhalb der Vakuumkammer befinden.

Die Schächte werden im einfachsten Fall durch in einem Kreis angeordnete Käfigstangen gebildet, die sich zwischen dem oberen und unteren Drehteller erstrecken.

Die Hubeinrichtungen, die als Spindelantriebe ausgebildet sind, besitzen jeweils einen seitlich abstehenden Ausleger, der in den zugehörigen, von Käfigstangen gebildeten Schacht eingreift.

Auf dem oberen Drehteller, der in einem Zwischenboden der Vakuumkammer drehbar gelagert ist, ist auf Hohlzylindern aufliegend ein Tiegelkopf angeordnet, in dessen Oberseite die Tiegel eingelassen sind. Die Hohlzylinder bilden jeweils eine Verlängerung der Schächte. Der Tiegelkopf ist mit Kühlkanälen versehen, die an einen Kühlwasseranschluss angeschlossen sind. Die Kühlwasserzufuhr erfolgt durch den unteren Drehteller.

Unterhalb der Oberkante des Tiegelkopfes und oberhalb des oberen Drehtellers befindet sich eine Blende, die sich über den Querschnitt der Vakuumkammer erstreckt und die gegebenenfalls gekühlt werden kann.

Im Folgenden soll anhand eines Ausführungsbeispieles die Erfindung näher erläutert werden. Dazu zeigen:
- Fig.1: eine Gesamtansicht der Vorrichtung,
- Fig.2: eine Detaildarstellung eines unteren Drehtellers,
- Fig.3: eine Sicht von unten auf die Vorrichtung und
- Fig.4: eine Sicht von oben auf die Vorrichtung.

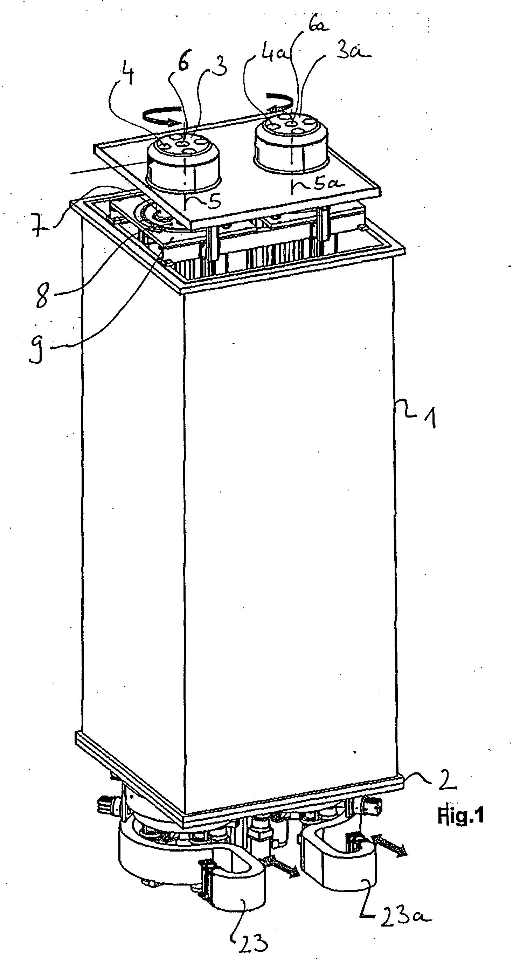

Die Fig. 1 zeigt eine erfindungsgemäße Vorrichtung, die in einer Vakuumkammer 1 angeordnet ist, deren unterer Teil dargestellt ist: Die Unterseite der im Querschnitt rechteckigen Vakuumkammer 1 ist durch eine Bodenplatte 2 geschlossen. Auf das offene obere Ende des unteren Teils der Vakuumkammer 1 ist eine nicht dargestellte Kondensationshaube vakuumdicht aufgesetzt. Die Haube umschließt eine Beschichtungszone, in der die Substrate an drehbaren Haltern angeordnet sind, die hier ebenfalls nicht dargestellt sind. Die drehbaren Halter erlauben es, die Substrate in einer Verdampfungswolke zu drehen, so dass sie allseitig beschichtet werden.

Eine Substrataufnahme besteht z. B. aus zwei länglichen, horizontal verlaufenden Haltern, an denen nebeneinander mehrere Substrate gehalten sind. Der Elektronenstrahl kann dann nur in einer Vertikalebene bewegt werden, die zwischen den zwei Haltern liegt. Bereiche seitlich dieser Ebene werden durch die Substrataufnahmen abgeschattet. Aus diesem Grund müssen die einzelnen Tiegel in die Vertikalebene hinein gedreht werden, damit sie vom Elektronenstrahl erreicht werden können.

Im vorliegenden Beispiel sind zwei erfindungsgemäße Vorrichtungen nebeneinander angeordnet. Es liegen somit zwei gleich aufgebaute Tiegelköpfe 3, 3a vor, die unterhalb der Beschichtungszone nebeneinander angeordnet sind. Die doppelte Anordnung ist notwendig, um in der Beschichtungszone eine ausgedehnte Verdampfungswolke zu schaffen, in denen eine Vielzahl von kleinen Substraten, z. B. Turbinenschaufeln, gleichzeitig beschichtet werden können.

Da die Vorrichtungen identisch aufgebaut sind, wird im Folgenden nur eine Vorrichtung näher beschrieben.

Jeder Tiegelkopf 3 besitzt vier Tiegel 4, die gleichmäßig verteilt auf einem Kreis um eine vertikal verlaufende Drehachse 5 der Vorrichtung angeordnet sind. Inmitten der Tiegel 4, vorzugsweise in der Drehachse 5, befindet sich ein weiterer Tiegel, nämlich ein Dummytiegel 6, der mit einem Dummymaterial versehen ist, das nicht der Beschichtung dient.

Der Tiegelkopf 3 ist auf vier Hohlzylindern 7 gelagert, die vertikal aufgestellt auf einem oberen Drehteller 8 angeordnet sind, der wiederum in einem Zwischenboden 9 in der Vakuumkammer drehbar gelagert ist. Die Hohlzylinder 7 bilden jeweils den oberen Abschnitt eines Schachtes 10, durch den jedem Tiegel 4 zu verdampfendes Material von unten zugeführt wird.

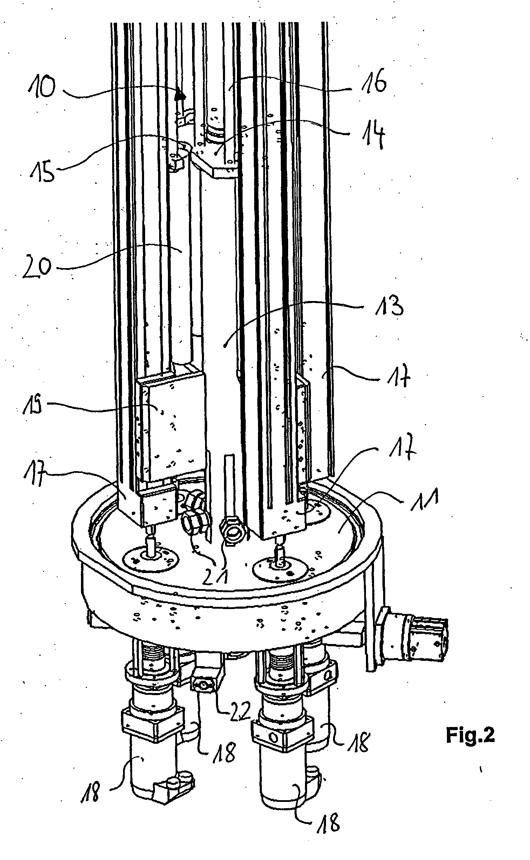

Des Weiteren ist, wie in der Figur 2 zu sehen ist, ein unterer Drehteller 11 im Boden der Vakuumkammer 1 angeordnet und ist dazu vakuumdicht in einem in der Bodenplatte 2 angeordneten Flansch 12 gelagert. Zwischen dem oberen und dem unteren Drehteller 8, 11 verläuft eine zentrale Säule 13. Auf einem im unteren Teil der Säule 13 vorhandenen Absatz sitzt eine Scheibe 14 mit vier randoffene Ausnehmungen 15, die mit den Hohlzylindern 7 auf dem oberen Drehteller 8 fluchten. Zu beiden Seiten einer jeden Ausnehmung 15 befinden sich Käfigstangen 16, die zusammen mit der zentralen Säule 13 einen Schacht 10 bilden. Es sind somit insgesamt vier Schächte 10 gebildet, die jeweils seitlich von zwei Käfigstangen 16 und rückwärtig von einer dritten Käfigstange begrenzt sind.

In den Schächten 10 wird das den Tiegeln 4 zuzuführende Material in Form von Vollzylindern aufeinander gestapelt, um eine Materialstange zu bilden, die von unten durch den zugehörigen Hohlzylinder 7 in den jeweiligen Tiegel 4 eingeführt wird. Der unterste Vollzylinder der Materialstange sitzt zunächst auf den Rand der Ausnehmung 15 auf.

Zwischen den jeweils radial außen liegenden Randbereichen des oberen und unteren Drehtellers 8, 11 ist parallel zu jedem Schacht jeweils eine Hubeinrichtung in Form eines Spindelantriebs 17 vorgesehen, dessen Spindelwelle durch den unteren Drehteller 11 über eine vakuumdichte Drehdurchführung nach außen geführt ist, wo sich für jeden Spindelantrieb 17 ein an der Unterseite des Drehtellers 11 befestigter Motor 18 befindet.

An jeder Spindelmutter ist ein nach innen gerichteter Ausleger 19 angeordnet, auf dem sich ein nach oben ragender Stift 20 befindet, der durch die randoffene Ausnehmung 15 in der Scheibe 14 in den zugehörigen Schacht 10 eingeführt werden kann. Die Länge des Stiftes 20 entspricht dabei der Länge der Hohlzylinder 7, so dass die Stifte 20 in den Tiegelkopf ragen, wenn der zugehörige Ausleger 19 vollständig nach oben gefahren ist. Dies erlaubt es, auch noch den kleinsten Rest an Material zu verdampfen.

Die Säule 13 ist durch den unteren Drehteller 11 hindurchgeführt und dient sowohl der Zuleitung von Kühlwasser zum Tiegelkopf 3 als auch der Durchführung von elektrischer Energie und elektrischen Signalen von und zu hier nicht näher dargestellten Sensoren in der Vakuumkammer 1. Dazu besitzt sowohl der innen liegende als auch der außen liegende Abschnitt der Säule 13 entsprechende Anschlüsse, die innerhalb der Säule miteinander in Verbindung stehen. Mit 21 ist ein innerer Wasseranschluss und mit 22 ein äußerer Wasseranschluss bezeichnet. Die Verbindung des inneren Wasseranschlusses 21 zu den Kühlkanälen im Tiegelkopf 3 erfolgt über hier nicht näher dargestellte Rohrleitungen.

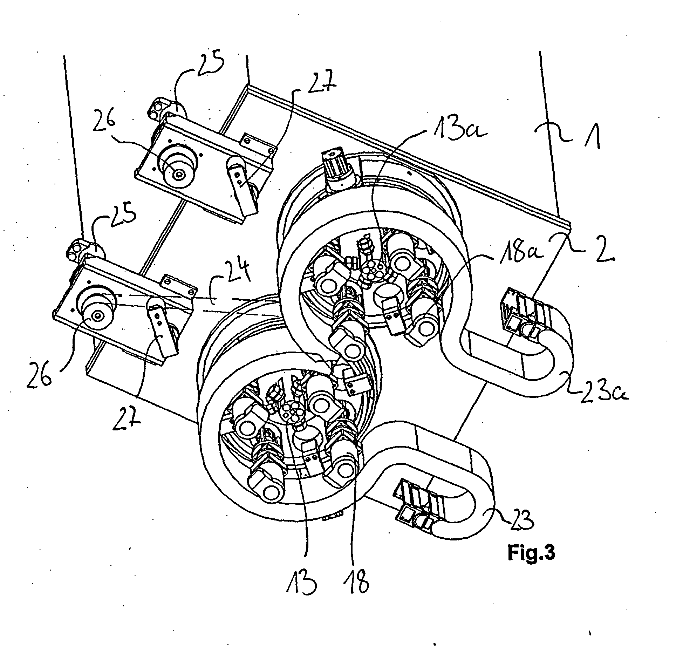

Wie Figur 3 entnommen werden kann, werden die Motoren 18 an den beiden unteren Drehtellern 11, 11a über aufwickelbare Medienanschlüsse 23, 23a mit Strom versorgt, über die auch die Datenerfassung der oben erwähnten Sensoren erfolgt.

Der untere Drehteller 11 wird von einen Zahnriemen 24 angetrieben, der über eine seitlich angeordnete und von einem Motor 25 angetriebene Rolle 26 verläuft und von einem Zahnriemenspanner 27 unter Spannung gehalten wird. Der Antrieb für den anderen Drehteller 11a ist identisch aufgebaut.

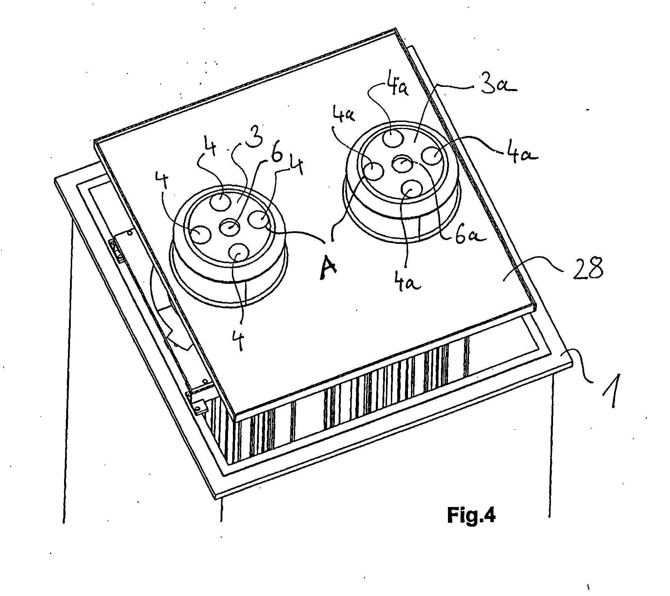

Gemäß Fig. 4 befinden sich die Tiegelköpfe 3, 3a der beiden Vorrichtungen in einer Ausdehnung einer gemeinsamen Blende 28, die verhindert, dass Material in die darunter liegenden Vorrichtungen gelangen kann, was zu Schäden führen könnte. Die Blende 28 ist so installiert, dass sie bei abgenommener Kondensationshaube zum Reinigen leicht entfernt werden kann.

Die Figur 4 zeigt eine Draufsicht auf zwei nebeneinander angeordnete erfindungsgemäße Vorrichtungen. Man erkennt zwei nebeneinander liegende Tiegelköpfe 3, 3a mit je vier Tiegeln 4, 4a und einem fünften im Zentrum liegenden Dummytiegel 6, 6a, der nicht über einen Schacht versorgt wird. Die Arbeitspositionen A der Tiegel 4, 4a liegen in einer Vertikalebene V unmittelbar gegenüber. Arbeitsposition ist die Position der Tiegel, auf die der jeweilige Elektronenstrahl gerichtet ist, um das sich im Tiegel befindende Material aufheizen und verdampfen zu können.

Die zu beschichtenden Substrate sind links und rechts der Vertikalebene V, die durch die beiden Arbeitspositionen A definiert ist, angeordnet, so dass die Bahn der Elektronenstrahlen in der Vertikalebene nicht behindert wird. Je nachdem, welches Material verdampft werden soll, wird einer der Tiegel 4, 4a, dessen Schacht mit dem entsprechenden Material bestückt ist, in die zugehörige Arbeitsposition A gedreht. Dazu wird jeweils die gesamte Vorrichtung um die vertikale Drehachse gedreht, indem die unteren Drehteller 11, 11a synchron angetrieben werden.

Während einer solchen Drehung kann der Elektronenstrahl auf den mittleren Dummytiegel 6 geleitet werden und ruht dort in einer Ruheposition, solange der Tiegelkopf 3 gedreht wird. Sobald sich ein neuer Tiegel 4 aus dem Tiegelkreis in der Arbeitsposition A befindet, wird der Elektronenstrahl in die Arbeitsposition A zurückgeleitet. Entsprechendes gilt für den anderen Tiegelkopf 3a.

Der Wechsel von der Ruheposition zur Arbeitsposition A braucht nicht in einem Schritt zu erfolgen, sondern kann durch eine alternierende Bewegung zwischen der Ruhe- und der Arbeitsposition erfolgen, da ein zu starker Eintrag von Energie in das noch kalte Material des neuen Tiegels zu Spritzerbildungen führen würde. Der Wechsel erfolgt so, dass in jeder Periode der alternierenden Bewegung die Dauer, mit der der Elektronenstrahl auf den neuen Tiegel in der Arbeitsposition A verbleibt, vergrößert wird. Des Weiteren kann auch seine Fokussierung gesteuert werden. Befindet sich der Elektronenstrahl im Dummytiegel 6, ist er defokussiert. Da bei einer Defokussierung der Elektronenstrahl seine Energie flächig und nicht punktuell einbringt, wird das Material nur wenig verdampft, so dass der Dummytiegel 6 keine Materialnachführung benötigt.

Weil während des Drehwechsels der Tiegel 4 als auch beim Aufheizen des neuen Tiegels der Elektronenstrahl nicht unterbrochen wird, kann stets dieselbe Energiemenge durch den Elektronenstrahl in den Tiegelkopf 3 und damit in die Beschichtungszone eingebracht werden, so dass die Temperatur darin aufrechterhalten bleibt. Dies betrifft auch die Substrate selbst, so dass die Beschichtungsqualität, die auch von der Temperatur beeinflusst wird, nicht beeinträchtigt ist.

### Bezugszeichenliste

- 1: Vakuumkammer
- 2: Bodenplatte
- 3: Tiegelkopf
- 4: Tiegel
- 5: Drehachse

- 6: Dummytiegel
- 7: Hohlzylinder
- 8: obere Drehteller
- 9: Zwischenboden

- 10: Schacht
- 11: untere Drehteller
- 12: Flansch
- 13: Säule
- 14: Scheibe
- 15: Ausnehmungen

- 16: Käfigstangen
- 17: Spindelantrieb
- 18: Motor
- 19: Ausleger
- 20: Stift

- 21: Wasseranschluss
- 22: Wasseranschluss
- 23: Medienanschluss
- 24: Zahnriemen
- 25: Motor

- 26: Rolle
- 27: Zahnriemenspanner
- 28: Blende

## Patentansprüche

1. Verfahren zum Betreiben einer Vorrichtung zum Beschichten von Substraten mit einem Beschichtungsmaterial nach dem EB/PVD-Verfahren mit einer aus wenigstens zwei Beschichtungsmaterial enthaltenden Tiegeln bestehenden Tiegelanordnung, **dadurch gekennzeichnet, dass** die Vorrichtung zusätzlich einen Dummytiegel aufweist, und dass der Elektronenstrahl bei einem Wechsel auf einen neuen Tiegel aus der Tiegelanordnung zunächst auf den Dummytiegel gelenkt wird.

2. Verfahren nach Anspruch 1, **dadurch gekennzeichnet, dass** der Elektronenstrahl bei einem Wechsel auf einen neuen Tiegel aus der Tiegelanordnung zwischen dem neuen Tiegel und dem Dummytiegel hin und her bewegt wird.

3. Verfahren nach Anspruch 1 oder 2, **dadurch gekennzeichnet, dass** der Elektronenstrahl defokussiert wird, wenn er sich auf dem Dummytiegel befindet.

4. Verfahren nach Anspruch 2, **dadurch gekennzeichnet, dass** der Elektronenstrahl im Bereich des neuen Tiegels zunächst defokussiert ist und mit jeder Periode der alternierenden Bewegung stärker fokussiert wird.

5. Verfahren nach Anspruch 2 oder 4, **dadurch gekennzeichnet, dass** mit jeder Periode die Verweildauer auf dem neuen Tiegel erhöht wird, bis sie vollständig ist und keine alternierende Bewegung mehr vollzogen wird.

6. Vorrichtung zum Beschichten von Substraten mit einem Beschichtungsmaterial nach dem EB/PVD-Verfahren mit einer aus wenigstens zwei Tiegeln (4) bestehenden Tiegelanordnung in einem Tiegelkopf, wobei jeder Tiegel (4) in einem ihm zugeordneten horizontal versetzbaren Gestell angeordnet ist und in jedem Gestell unterhalb des jeweiligen Tiegels (4) ein Schacht (10) zur Aufnahme einer aus dem Beschichtungsmaterial bestehenden Materialstange angeordnet ist, und mit mindestens einer Hubeinrichtung, mit deren Hilfe eine in dem Schacht (10) angeordnete Materialstange durch den Boden des Tiegels (4) in den Tiegel (4) einführbar ist, um dort durch den Beschuss mit einem Elektronenstrahl aus einer Elektronenkanone verdampft zu werden, **dadurch gekennzeichnet, dass** jedem Tiegel (4) genau ein Schacht (10) und genau eine Hubeinrichtung zugeordnet ist und dass die Hubeinrichtungen und der jeweils zugehörige Schacht (10) auf dem dem Tiegel (4) zugehörigen Gestell angeordnet sind und mit diesen seitlich versetzt werden, und dass sich im Tiegelkopf (3) ein weiterer Tiegel (6) befindet, der über keine Materialstangenzufuhr verfügt.

7. Vorrichtung nach Anspruch 6, **dadurch gekennzeichnet, dass** in diesem weiteren Tiegel (6) ein zu verdampfendes Material eingebracht ist.

8. Vorrichtung nach Anspruch 6 oder 7, **dadurch gekennzeichnet, dass** die Gestelle Teilbereiche eines Karussells sind, das um eine vertikale Achse drehbar angeordnet ist.

9. Vorrichtung nach Anspruch 8, **dadurch gekennzeichnet, dass** die Tiegel (4) um die vertikal ausgerichtete Achse des Karussells herum angeordnet sind.

10. Vorrichtung nach Anspruch 9, **dadurch gekennzeichnet, dass** das Karussell einen oberen Drehteller (8) und einen unteren Drehteller (11) aufweist, wobei der untere Drehteller (11) vakuumdicht im Boden der Vakuumkammer (1) gelagert ist.

11. Vorrichtung nach Anspruch 10, **dadurch gekennzeichnet, dass** die Antriebswellen für die Hubeinrichtungen durch den unteren Drehteller (11) vakuumdicht hindurchgeführt sind, so dass sich die Motoren (18) für die einzelnen Antriebswellen außerhalb der Vakuumkammer (1) befinden.

12. Vorrichtung nach Anspruch 6 oder 7, **dadurch gekennzeichnet, dass** die Schächte (10) durch in einem Kreis angeordnete Käfigstangen (16) gebildet sind, die sich zwischen dem oberen und unteren Drehteller (8, 11) erstrecken.

13. Vorrichtung nach Anspruch 12, **dadurch gekennzeichnet, dass** die Hubeinrichtungen, die als Spindelantriebe (17) ausgebildet sind, jeweils einen seitlich abstehenden Ausleger (19) besitzen, der in den durch die Käfigstangen (16) gebildeten Schacht (10) eingreift.

14. Vorrichtung nach Anspruch 13, **dadurch gekennzeichnet, dass** ein Tiegelkopf (3) zur Aufnahme der Tiegel (4) auf dem oberen Drehteller (8), der in einem Zwischenboden (9) der Vakuumkammer (1) gelagert ist, mittels Hohlzylinder (7), die eine Fortsetzung der Schächte (10) bilden, aufgestellt ist.

15. Vorrichtung nach Anspruch 14, **dadurch gekennzeichnet, dass** der Tiegelkopf (3) mit Kühlkanälen versehen ist, die an einen Kühlwasseranschluss (21) angeschlossen sind, wobei die Kühlwasserzufuhr über den unteren Drehteller (11) erfolgt.

16. Vorrichtung nach Anspruch 6 oder 7, **dadurch gekennzeichnet, dass** sich unterhalb der Oberkante des Tiegelkopfes (3) und oberhalb des oberen Drehtellers (8) eine Blende (28) befindet, die sich über den Querschnitt der Vakuumkammer (1) erstreckt.

## Claims

1. A method for operating an apparatus for coating substrates with a coating material using the EB/PVD process, with a crucible arrangement comprising at least two crucibles containing coating material, **characterised in that** the apparatus also comprises a dummy crucible, and that the electron beam is first directed onto the dummy crucible when there is a change to a new crucible of the crucible arrangement.

2. The method according to claim 1, **characterised in that**, when there is a change to a new crucible of the crucible arrangement, the electron beam is moved back and forth between the new crucible and the dummy crucible.

3. The method according to claim 1 or 2, **characterised in that** the electron beam is defocused when it is located on the dummy crucible.

4. The method according to claim 2, **characterised in that** the electron beam is at first defocused in the region of the new crucible and is focused more sharply with each period of the alternating movement.

5. The method according to claim 2 or 4, **characterised in that** the dwell time on the new crucible is increased with each period until it is complete and no further alternating movement is performed.

6. An apparatus for coating substrates with a coating material using the EB/PVD process, with a crucible arrangement in a crucible head, said crucible arrangement comprising at least two crucibles (4), wherein each crucible (4) is disposed in a horizontally displaceable frame assigned to it and a shaft (10) for receiving a material bar comprised of the coating material is disposed in each frame beneath the respective crucible (4), and with at least one lifting device, by means of which a material bar disposed in the shaft (10) can be fed into the crucible (4) through the bottom of the crucible (4) in order to be evaporated there by bombardment with an electron beam from an electron gun, **characterised in that** precisely one shaft (10) and precisely one lifting device is assigned to each crucible (4) and that the lifting devices and the respectively associated shaft (10) are disposed on the frame associated with the crucible (4) and are displaced laterally with the latter, and that a further crucible (6), which does not have a material bar feed, is located in the crucible head (3).

7. The apparatus according to claim 6, **characterised in that** a material to be evaporated is introduced into this further crucible (6).

8. The apparatus according to claim 6 or 7, **characterised in that** the frames are partial regions of a carousel which is disposed rotatably around a vertical axis.

9. The apparatus according to claim 8, **characterised in that** the crucibles (4) are disposed around the vertically orientated axis of the carousel.

10. The apparatus according to claim 9, **characterised in that** the carousel comprises an upper rotary disc (8) and a lower rotary disc (11), wherein the lower rotary disc (11) is mounted vacuum-tight in the base of the vacuum chamber (1).

11. The apparatus according to claim 10, **characterised in that** the drive shafts for the lifting devices are passed vacuum-tight through the lower rotary disc (11), so that the motors (18) for the individual drive shafts are located outside the vacuum chamber (1).

12. The apparatus according to claim 6 or 7, **characterised in that** the shafts (10) are formed by cage rods (16) disposed in a circle, said cage rods extending between the upper and lower rotary discs (8, 11).

13. The apparatus according to claim 12, **characterised in that** the lifting devices, which are constituted as spindle drives (17), each comprise a laterally projecting extension arm (19) which engages in the shaft (10) formed by the cage rods (16).

14. The apparatus according to claim 13, **characterised in that** a crucible head (3) for receiving the crucibles (4) is positioned on the upper rotary disc (8) by means of hollow cylinders (7) which form an extension of the shafts (10), said upper rotary disc being mounted in an intermediate base (9) of the vacuum chamber (1).

15. The apparatus according to claim 14, **characterised in that** the crucible head (3) is provided with cooling channels which are connected to a cooling water connection (21), wherein the cooling water supply takes place via the lower rotary disc (11).

16. The apparatus according to claim 6 or 7, **characterised in that** a diaphragm (28), which extends over the cross-section of the vacuum chamber (1), is located beneath the upper edge of the crucible head (3) and above the upper rotary disc (8).

## Revendications

1. Procédé pour l'utilisation d'un dispositif de revêtement de substrats avec un matériau de revêtement selon le procédé de dépôt par évaporation sous bombardement électronique avec un agencement de creusets composé d'au moins deux creusets contenant du matériau de revêtement **caractérisé en ce que** le dispositif présente en plus un creuset factice et **en ce que** le faisceau d'électrons est d'abord dirigé sur le creuset factice lors d'un changement sur un nouveau creuset de l'agencement de creusets.

2. Procédé selon la revendication 1 **caractérisé en ce que** le faisceau d'électrons lors d'un changement effectue un mouvement de va-et-vient sur un nouveau creuset de l'agencement de creusets entre le nouveau creuset et le creuset factice.

3. Procédé selon la revendication 1 ou 2 **caractérisé en ce que** le faisceau d'électrons est déconcentré s'il se trouve sur le creuset factice.

4. Procédé selon la revendication 2 **caractérisé en ce que** le faisceau d'électrons est d'abord déconcentré dans la zone du nouveau creuset et est plus fortement concentré avec chaque période de mouvement alternatif.

5. Procédé selon la revendication 2 ou 4 **caractérisé en ce qu'**avec chaque période la durée de maintien sur le nouveau creuset est augmentée jusqu'à ce qu'elle soit complète et qu'aucun mouvement alternatif n'est plus effectué.

6. Dispositif de revêtement de substrats avec un matériau de revêtement selon le procédé de dépôt par évaporation sous bombardement électronique avec un agencement de creusets dans une tête à creusets composé d'au moins deux creusets (4), pour lequel chaque creuset (4) est disposé dans un châssis déplaçable horizontalement qui lui est attribué et un puits (10) est disposé dans chaque châssis sous le creuset (4) respectif pour recevoir une barre de matériau composée du matériau de revêtement et avec au moins un système de levage à l'aide duquel une barre de matériau disposée dans le puits (10) peut être introduite par le fond du creuset (4) dans le creuset (4) pour y être évaporée par le bombardement avec un faisceau d'électrons d'un canon à électrons **caractérisé en ce qu'**à chaque creuset(4) est attribué exactement un puits (10) et exactement un système de levage et **en ce que** les systèmes de levage et le puits (10) respectivement correspondant sont disposés sur le châssis correspondant au creuset (4) et sont décalés latéralement avec ceux-ci et **en ce qu'**un autre creuset (6) se trouve dans la tête à creusets (3) qui ne dispose d'aucune alimentation en barre de matériau.

7. Dispositif selon la revendication 6 **caractérisé en ce que** dans cet autre creuset (6) est introduit un matériau à évaporer.

8. Dispositif selon la revendication 6 ou 7 **caractérisé en ce que** les châssis sont des zones partielles d'un carrousel qui est disposé rotatif autour d'un axe vertical.

9. Dispositif selon la revendication 8 **caractérisé en ce que** les creusets (4) sont disposés autour de l'axe de carrousel orienté verticalement.

10. Dispositif selon la revendication 9 **caractérisé en ce que** le carrousel comporte un plateau pivotant (8) supérieur et un plateau pivotant (11) inférieur, le
plateau pivotant (11) inférieur étant monté étanche au vide dans le fond de la chambre de vide (1).

11. Dispositif selon la revendication 10 **caractérisé en ce que** les arbres de transmission pour les systèmes de levage sont passés de façon étanché au vide à travers le plateau pivotant (11) inférieur de sorte que les moteurs (18) pour les arbres de transmission individuels se trouvent en dehors de la chambre de vide (1).

12. Dispositif selon la revendication 6 ou 7 **caractérisé en ce que** les puits (10) sont formés par des barres de cage (16) disposées dans un cercle qui s'étendent entre le plateau pivotant supérieur et le plateau pivotant inférieur (8, 11).

13. Dispositif selon la revendication 12 **caractérisé en ce que** les systèmes de levage qui sont constitués comme des entraînements par vis sans fin (17), possèdent respectivement une console (19) s'écartant latéralement qui vient en prise dans le puits (10) formé par les barres de cage (16).

14. Dispositif selon la revendication 13 **caractérisé en ce qu'**une tête à creusets (3) pour réception des creusets (4) est posée sur le plateau pivotant (8) supérieur qui est monté dans un fond intermédiaire (9) de la chambre de vide (1) au moyen de cylindres creux (7) qui forment un prolongement des puits (10).

15. Dispositif selon la revendication 14 **caractérisé en ce que** la tête à creusets (3) est munie de conduits de refroidissement qui sont raccordés à un raccord d'eau de refroidissement (21), l'alimentation en eau de refroidissement ayant lieu par le plateau pivotant (11) inférieur.

16. Dispositif selon la revendication 6 ou 7 **caractérisé en ce que** sous le bord supérieur de la tête à creusets (3) et au-dessus du plateau pivotant (8) supérieur se trouve un écran (28) qui s'étend sur la section de la chambre de vide (1).
